# EUROPEAN PATENT APPLICATION

(11) **EP 2 017 956 A1**
(43) Date of publication of application: **21.01.2009**
(21) Application number: 07014122.1
(22) Date of filing: 18.07.2007
(51) Int. Cl.: H03F 3/21, H03F 3/68, H04B 1/04

(54) **Radio signal amplifying device and method for generating and for amplifying a radio frequency signal**

(71) Applicant: Nokia Siemens Networks Oy, 02610 Espoo (FI)
(72) Inventor: Heinz, Helmut, 86842 Türkheim (DE); Jelonnek, Björn, Dr., 89079 Ulm (DE); Splett, Armin, Dr., 89079 Ulm (DE)
(74) Representative: Bruglachner, Thomas E.

(57) **Abstract**

The invention relates to a radio signal amplifying device including an input interface (10) for inputting a signal to be transmitted, means for generating a high-frequency radio signal encoding said signal using at least one carrier frequency (TW), a signal amplifying arrangement (12) for amplifying said high-frequency radio signal, and a signal output (14) for outputting the amplified radio signal to be transmitted by an antenna.

In order to enable a flexible adaptation of the radio signal amplifying device to varying total output power requirements, it is proposed that said signal amplifying arrangement (12) comprises at least two signal amplifiers (18a, 18b) being arranged in parallel. The radio signal amplifying device may further comprise a signal combining means (20) for combining the signals from the two amplifiers (18a, 18b), said signal combining means (20) comprising at least one phase matching means (22) for matching the phases of said signals.

## Description

### Technical field of the invention

The invention relates to a radio signal amplifying device according to the preamble of claim 1 and to a method for generating and for amplifying a radio frequency signal according to the preamble of claim 14.

### Background of the invention

Modern communication networks for mobile communication rely on a large amount of widely distributed base stations or nodes for receiving and sending signals from and to mobile user terminals being camped inside the range of the respective base station. The base stations are provided with a limited number of antennas for sending a signal to be transmitted.

The signals are coded using a certain set of mutually orthogonal carrier frequencies, wherein the signals are imprinted on the carrier waves using some known coding scheme based e.g. on an amplitude modulation or on a phase modulation.

Since the number of signals or data streams to be transmitted varies depending on the number of active user equipments within a wide range, and since the number of signals to be transmitted may easily exceed the number of antennas of the base station, the total power radiated by the antenna may vary to the same extent.

In order to achieve the desired total power on the antenna, the amplifiers used to generate the input signals for the antennas have to be of high quality and may be very expensive.

Moreover, since the range, the average number, and the maximum number of signals to be transmitted varies largely from base station to base station, it is important to adapt the amplifiers in the base stations to the specific circumstances in order to operate the amplifiers in an optimum range and to avoid unnecessary costs.

However, the decisive circumstances may vary in time, such that it may become necessary to replace one or more of the radio signal amplifiers in the base station. If e.g. the average number of signals increases, an amplifier with a higher output power may be required.

In order to cope with this problem, it has been known to provide a portfolio of radio signal amplifiers with different output power. However, this results in increased efforts in the development, test and stock-keeping of the amplifiers. Since the portfolios are not redundant, the availability of amplifiers of a specific type may be limited. If the output power has to be increased, the smaller amplifier has to be replaced with the larger amplifier. The smaller amplifier has to be discarded or recycled in a ring-exchange system, where the latter solution results in increased efforts for the logistics.

Furthermore, it is known to construct amplifiers with a smaller output power in a way that a so-called "booster" can be added in order to upgrade the radio signal amplifier and to increase the total output power. However, the hardware enabling an optional upgrade has the be provided and may turn out to be unnecessary in most of the cases.

### Summary of the Invention

The object of the invention is to provide a radio signal amplifying device and a method for generating and for amplifying a radio frequency signal with increased flexibility and enhanced scalability. In particular, the invention seeks to provide an amplifying arrangement of modular type, wherein the total output power can easily be increased or decreased by adding or removing modules.

According to one aspect of the invention, a radio signal amplifying device is proposed, the device including a digital input interface for inputting a signal to be transmitted, means for generating a high-frequency radio signal encoding said signal using at least one carrier frequency, a signal amplifying arrangement for amplifying said high-frequency radio signal, and a signal output for outputting the amplified radio signal to be transmitted by an antenna.

It is proposed that said signal amplifying arrangement comprises at least two signal amplifiers being arranged in parallel. The radio signal amplifying device may further comprise a signal combining means for combining the signals from the two amplifiers and at least one phase matching means for matching the phases of said signals. One of the central ideas of the invention is to provide an amplifying arrangement where two or more amplifiers may be used in parallel in order to achieve a desired output power and to provide means for coherently adding the signals of the individual amplifiers. The total output power can easily be increased or decreased by adding or removing one or more of the parallel amplifiers.

Here and in the following, the term "coherent" refers to the synchronization of the phases of the signals. The phase of at least one of the signals is controlled to be essentially equal to the phase of the other signal.

In principle, the invention can be applied together with any coding scheme. However, it has turned out to be particularly fruitful to use the invention in wideband Code-Division Multiple Access (CDMA) schemes.

The input interface may be an analogue signal input interface, but is favourably formed as a digital input interface, wherein a digital to analogue converter may be arranged between the input interface and the amplifiers in the latter case. In order to extend the digital signal processing as far as possible, the digital to analogue converter may be placed immediately before the input of the power amplifiers.

In a further advantageous embodiment, it is proposed that the radio signal amplifying device comprises at least two means for generating a high-frequency radio signal encoding said signal using at least one carrier frequency, said means being associated to one of the signal amplifiers respectively. The signal amplifiers and the means or generating the high-frequency radio signal can be combined to form functional entities which can be added or removed as independent combined amplifier and transceiver modules and which can be used as a stand-alone signal generating and amplifying device.

In particular, the device may comprise two or more essentially identical combined amplifier and transceiver modules being arranged in parallel, each of the modules comprising one signal amplifier and one of said means for generating a high-frequency radio signal.

In order to control the coherence of the combined signal, it is proposed that the signal combining means is configured to separate off an incoherent contribution of the signals. In order to achieve a reliable and precise phase control, the phase matching means is configured to use the incoherent contribution for matching the phases. Since a perfect phase match corresponds to zeroing the incoherent contribution, this control scheme is particularly precise.

According to a further aspect of the invention, it is proposed that the phase matching means is configured to adjust the phase of at least one of the signals by minimizing the electrical power in the incoherent contribution of the signals. Since the power can be very easily detected, this avoids expensive circuitry and high-frequency components.

In a particularly simple and economic embodiment, the phase matching means may comprise a diode detector for measuring the power in the incoherent contribution of the signals.

A linear characteristic of the total arrangement can be achieved despite of the use of non-perfect amplifiers if each of the amplifiers is associated to a digital pre-distortion device for compensating a non-linearity of the respective amplifier.

Additional calculation units for the phase adjustment can be avoided if said phase matching means comprises the digital pre-distortion device, wherein the digital pre-distortion device adds a phase shift to the signal in order to minimize the incoherent contribution of the signal.

Moreover, the radio signal amplifying device may comprise an analogue to digital converter for converting signal representative of the power in the incoherent contribution of the combined signals in the signal combining means and for feeding the digitized signal into the digital pre-distortion device.

A feedback of the phase relation of the signals can be achieved in a particularly simple way if the signal combining means is configured to reflect an incoherent contribution of the signals and if at the same time the radio signal amplifying device is configured to detect the reflected part of the signal.

The reflected signal can be detected in a simple way without perturbing the transmission if the radio signal amplifying device comprises a circulator for separating off the signal reflected from the signal combining means.

A further aspect of the invention relates to a method for generating and for amplifying a radio frequency signal wherein a high-frequency radio signal encoding a signal to be transmitted is generated using at least one carrier frequency, the high-frequency radio signal is amplified using an amplifying arrangement and the signal is out put to be transmitted by an antenna.

It is proposed that the method comprises the step of dividing said signal in two parts each being amplified by one of at least two signal amplifiers being arranged in parallel and the step of combining the amplified signals from the two amplifiers using a signal combining means. The method may further comprise the step of matching the phases of said signals. Due to the parallel amplification and the phase matching, a flexible and modular amplification arrangement may be used.

### Brief description of the drawings

More characterizing features of the invention and advantages thereof will become apparent from the accompanying drawings. The drawings and the embodiments of the invention to be described below contain multiple features in combination. The skilled person will appreciate the advantages of the characterizing features of the invention taken singly or in further combinations being adapted to particular fields of application. The embodiments described below are examples only and are not meant to reduce the scope of the invention to be protected.
Fig. 1 is a schematic diagram of a radio signal amplifying device according to a first embodiment of the invention, and
Fig. 2 is a schematic diagram of a radio signal amplifying device according to a second embodiment of the invention.

### Detailed description of the embodiments

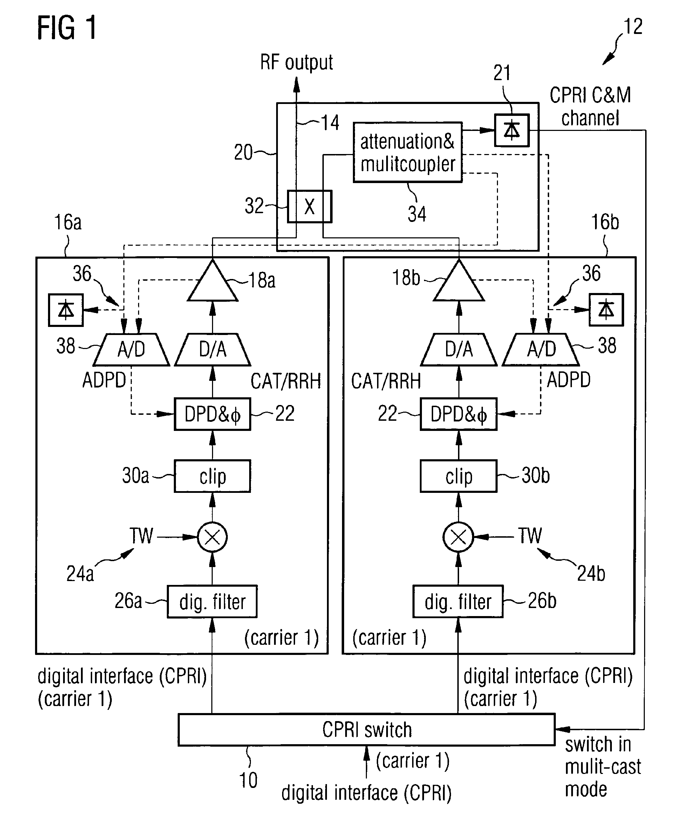

Figure 1 is a schematic diagram of a radio signal amplifying device according to a first embodiment of the invention. The radio signal amplifying device includes a digital input interface 10 for inputting a signal to be transmitted, means for generating a high-frequency radio signal encoding said signal using at least one carrier frequency TW, a signal amplifying arrangement 12 for amplifying said high-frequency radio signal, and a signal output 14 for outputting the amplified radio signal to be transmitted by an antenna.

In the embodiment shown in Figure 1, the radio signal amplifying device comprises two identical combined amplifier and transceiver modules 16a, 16b being arranged in parallel, each of said modules comprising one signal amplifier 18a, 18b and one of the means for generating a high-frequency radio signal.

As a consequence, the signal amplifying arrangement 12 comprises two signal amplifiers 18a, 18b being arranged in parallel. The radio signal amplifying device further comprises a signal combining means 20 for combining the signals from the two amplifiers 18a, 18b. The signal combining means 20 uses a phase matching means 22 for matching the phases of the signals generated by the amplifiers 18a, 18b.

The digital input interface 10 is a Common Public Radio Interface (CPRI) - switch which selects the input signal to be transmitted over the antenna and may be used in a single carrier mode and in a multicast mode depending on a setting. The CPRI-switch has a digital interface and divides the signal into two parallel signals each being fed into one of the combined amplifier and transceiver modules 16a, 16b. Although Figure 1 shows only one signal to be transmitted using one carrier, the generalization to multiple carriers is straightforward.

Each of the combined amplifier and transceiver modules 16a, 16b comprises a means 24a, 24b for generating a digital high-frequency radio signal encoding the signal using at least one carrier frequency TW. The latter means 24a, 24b are associated to one of the signal amplifiers 18a, 18b respectively.

The means 24a, 24b for generating a high-frequency radio signal comprises a digital filter 26a, 26b, a multiplier 28a, 28b and a clipping circuit 30a, 30b. The digital filter 26a, 26b removes unwanted sidebands from the signal and is formed as a root-raised cosine filter in order to regulate the occupied bandwidth.

After having passed the digital filter 26a, 26b, the signal from the CPRI-switch is fed into the multiplier 28a, 28b and is multiplied with the digitized carrier frequency TW signal. The multiplication is a complex multiplication using the real part and the imaginary part of the carrier wave signal.

The output of the multiplier 28a, 28b is subjected to the clipping circuit 30a, 30b which clips the amplitude of the signal at predetermined maximum amplitude in order to avoid damages in the amplifier 18a, 18b and to achieve good signal quality with limited distortions at high power efficiency in the power amplifier 18a, 18b..

Each of the amplifiers 18a, 18b is associated to a digital pre-distortion device DPD contained in the respective combined amplifier and transceiver module 16a, 16b. The output of the clipping circuit 30a, 30b is fed into the digital pre-distortion device DPD. The digital pre-distortion device DPD applies a functional operation to the signal which essentially corresponds to the inverse of the characteristic of the respective amplifier 18a, 18b. As a consequence, the digital pre-distortion device DPD compensates a non-linearity of the amplifier 18a, 18b and assures an overall linear behaviour of the amplifier 18a, 18b combined with the digital pre-distortion device DPD.

The digital pre-distortion device DPD is followed by a digital to analogue converter D/A generating an analogue input for the amplifier 18a, 18b.

The output of the amplifier 18a, 18b is fed into a coaxial input of the signal combining means 20. The signal combining means 20 has a coupler 32 being configured to separate off an incoherent contribution of the signals.

The incoherent contribution is fed into an attenuator and multicoupler 34 attenuating the signal. The attenuated signal is fed back from the signal combining means 20 into the two combined amplifier and transceiver modules 16a, 16b respectively, rectified using a diode detector device 36 and converted into a digital signal using an analogue to digital converter 38.

The phase matching means 22 is configured to use the incoherent contribution in order to match the phases of the signal from the modules 16a, 16b. The phase matching means 22 is comprised in the digital pre-distortion device DPD. The latter device is a fast integrated circuit equalizing the signal for the pre-distortion and adding a phase shift for the phase matching. The digital pre-distortion device DPD adds a phase shift to the signal in order to minimize the incoherent contribution of the signal. For broadband signals, the phase shift can be a function of the frequency in order to achieve sufficient coherence over the whole signal bandwidth. In this case, the phase shift function can be composed as a linear superposition of a limited number of phase shift functions over frequency, each being multiplied with a specific coefficient. All specific coefficients can be determined jointly using a standard - multidimensional - variational algorithm for minimizing the electrical power in the incoherent contribution of the signals. Due to the diode detector device 36, the signal converted by the analogue to digital converter 38 represents the power in the incoherent contribution of the signals.

In a different embodiment the output of the attenuator and multicoupler 34 is connect to a power detector 21 which is not located in any of the modules 16a or 16b, but is formed as a separate power detector 21 which could be part of the signal combining means 20. The output signal of this power detector 21 is digitized and sent as digital control message to at least one of the modules 16a or 16b. For this digital control message a control and monitoring (C&M) channel of the CPRI protocol can be used from the CPRI switch 10 to the modules 16a and 16b. This avoids additional interfaces since CPRI is also used for inputting the digital baseband signal to the modules 16a and 16b.

Depending on the circumstances, the skilled person will use interface protocols other than CPRI for sending the digital control message, especially for the signalling connection from the signal combining means 20 to the CPRI switch 10. For example, a CAN-bus or RS232 could be used. The digital control message is received by at least one of the modules 16a or 16b and used for determination of the phase offset.

In the latter embodiment, the multicoupler functionality of the attenuator and multicoupler 34 is not needed. In this case, it would only be an attenuator to protect the power detector 21 from damage. In further embodiment, the attenuator 34 is not required and the incoherent output of the signal combiner 32 is directly input to the power detector.

Figure 1 shows a further optional embodiment of the invention with a dashed line, wherein the output of the amplifier 18a, 18b is directly fed back into the digital pre-distortion device DPD via the analogue to digital converter 38 in order to control the characteristic of the digital pre-distortion device DPD in a closed feedback loop and to achieve a linear behaviour.

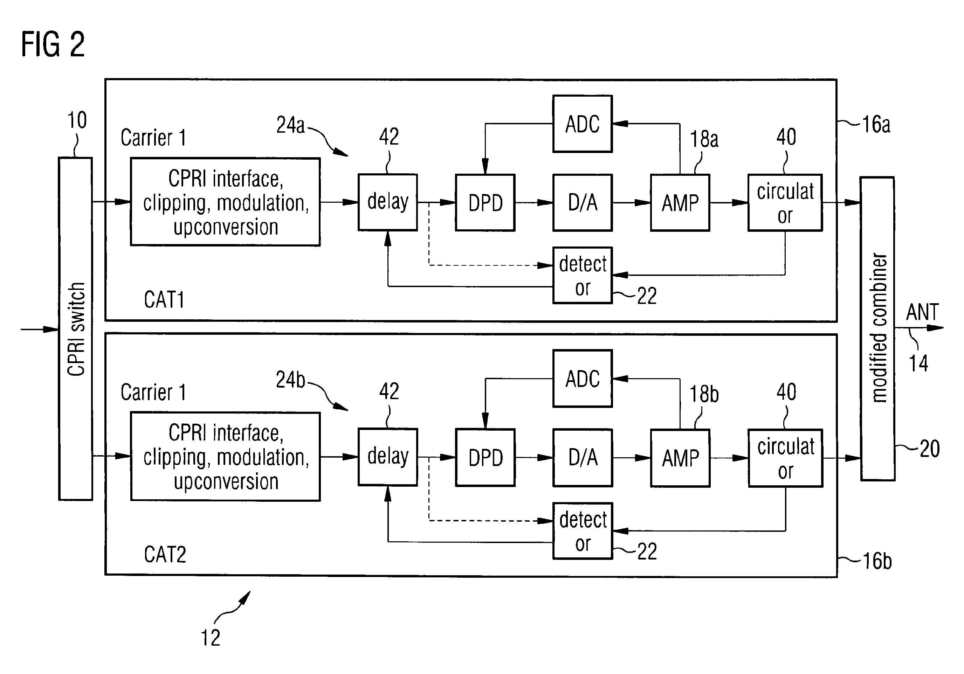

Figure 2 is a schematic diagram of a radio signal amplifying device according to a second embodiment of the invention. The following description focuses on the differences to the embodiment of Figure 1, whereas we confer to the above description of the first embodiment for unaltered features. Similar features are represented using the same reference numerals.

The radio signal amplifying device according to Figure 2 comprises a modified signal combining means 20 comprising a modified Wilkinson power divider (which is used as a power combiner). Instead of the ideally chosen resistance of a lossless Wilkinson power divider, a resistance with a non-ideal resistance value is used for connecting the two branches of the power divider arrangement. As a consequence, the two inputs are not perfectly decoupled at the carrier frequency TW.

Due to the coupling of the input signals stemming from the two combined amplifier and transceiver modules 16a, 16b of the radio signal amplifying device, an incoherent contribution of the combined signal is reflected from the modified signal combining means 20.

A circulator 40 arranged between the output of the amplifier 18a, 18b and the output of the combined amplifier and transceiver module 16a, 16b separates off the signal reflected from the signal combining means 20. The circulator 40 feeds the reflected signal into a detector. The detector is working as a phase matching means 22 and controls a phase delay element 42 in an optionally closed control loop.

The above described devices implement a method for generating and for amplifying a radio frequency signal wherein a high-frequency radio signal encoding a signal to be transmitted is generated using at least one carrier frequency TW, the high-frequency radio signal is amplified using an amplifying arrangement and the signal is output to be transmitted by an antenna.

According to the invention, the method comprises the step of dividing the signal in two parts each being amplified by one of at least two signal amplifiers 18a, 18b being arranged in parallel and the step of combining the amplified signals from the two amplifiers 18a, 18b using a signal combining means 20. The method further comprises matching the phases of the signals to be combined in the signal combining means 20.

## Claims

1. Radio signal amplifying device including:
- an input interface (10) for inputting a signal to be transmitted,
- means for generating a high-frequency radio signal encoding said signal using at least one carrier frequency (TW),
- a signal amplifying arrangement (12) for amplifying said high-frequency radio signal, and
- a signal output (14) for outputting the amplified radio signal to be transmitted by an antenna,
**characterized in that**
said signal amplifying arrangement (12) comprises
- at least two signal amplifiers (18a, 18b) being arranged in parallel,
- a signal combining means (20) for combining the signals from the two amplifiers (18a, 18b), and
- at least one phase matching means (22) for matching the phases of said signals.

2. Radio signal amplifying device according to claim 1,
**characterized by** comprising at least two means for generating a high-frequency radio signal encoding said signal using at least one carrier frequency (TW), said means being associated to one of the signal amplifiers (18a, 18b) respectively.

3. Radio signal amplifying device according to claim 2,
**characterized by** comprising at least two essentially identical combined amplifier and transceiver modules (16a, 16b ) being arranged in parallel, each of said combined amplifier and transceiver modules (16a, 16b ) comprising one signal amplifier (18a, 18b) and one of said means for generating a high-frequency radio signal.

4. Radio signal amplifying device according to one of the preceding claims,
**characterized in that**
said signal combining means (20) is configured to separate off an incoherent contribution of the signals, wherein the phase matching means (22) is configured to use the incoherent contribution in order to match the phases.

5. Radio signal amplifying device according to claim 4,
**characterized in that**
said phase matching means (22) is configured to adjust the phase of at least one of the signals by minimizing the electrical power in the incoherent contribution of the signals.

6. Radio signal amplifying device according to claim 5,
**characterized in that**
said phase matching means (22) comprises a diode detector for measuring the power in the incoherent contribution of the signals.

7. Radio signal amplifying device according to at least one of the preceding claims,
**characterized in that**
each of said amplifiers (18a, 18b) is associated to a digital pre-distortion device (DPD) for compensating a non-linearity of the respective amplifier (18a, 18b).

8. Radio signal amplifying device according to claim 7,
**characterized in that**
said phase matching means (22) comprises the digital pre-distortion device (DPD), wherein the digital pre-distortion device (DPD) adds a phase shift to the signal in order to minimize the incoherent contribution of the signal.

9. Radio signal amplifying device according to claim 8,
**characterized by** comprising an analogue to digital converter (38) for converting signal representative of the power in the incoherent contribution of the combined signals in the signal combining means (20) and for feeding the digitized signal into the digital pre-distortion device (DPD).

10. Radio signal amplifying device according to at least one of the preceding claims,
**characterized in that** signal combining means (20) is configured to reflect an incoherent contribution of the signals, said radio signal amplifying device being configured to detect the reflected signal.

11. Radio signal amplifying device according to claim 10, **characterized by** comprising a circulator (40) for separating off the signal reflected from the signal combining means (20).

12. Radio signal amplifying device according to at least one of the preceding claims,
**characterized in that** the input interface (10) is formed as a digital input interface (10) and that a digital to analogue converter (D/A) is arranged between the digital input interface (10) and the amplifiers (18a, 18b).

13. Combined amplifier and transceiver module (16a, 16b ) to be used in a radio signal amplifying device according to one of the preceding claims, **characterized by** comprising a signal amplifier (18a, 18b), a means for generating a high-a radio signal and a phase matching means (22) for matching the phases of the amplified signal to the phase of the signals generated by at least one other combined amplifier and transceiver module (16a, 16b ).

14. Method for generating and for amplifying a radio frequency signal wherein
- a high-frequency radio signal encoding a signal to be transmitted is generated using at least one carrier frequency (TW),
- the high-frequency radio signal is amplified using an amplifying arrangement
- the signal is to be transmitted by an antenna,
**characterized by** comprising the steps of:
- dividing said signal in two parts each being amplified by one of at least two signal amplifiers (18a, 18b) being arranged in parallel,
- combining the amplified signals from the two amplifiers (18a, 18b) using a signal combining means (20) and
- matching the phases of said signals.
